# EUROPÄISCHE PATENTSCHRIFT

(11) **EP 1 389 871 B1**
(45) Veröffentlichungstag und Bekanntmachung des Hinweises auf die Patenterteilung: **07.05.2008**
(21) Anmeldenummer: 03017701.8
(22) Anmeldetag: 02.08.2003
(51) Int. Cl.: H04N 5/44, H04N 5/50

(54) **Belegen von Speicherplätzen mit Diensten**
Occupying memory locations with services
Occupation d'emplacements de mémoire avec des services

(30) Priorität: 16.08.2002 DE 10238330
(43) Veröffentlichungstag der Anmeldung: 18.02.2004
(73) Patentinhaber: LOEWE OPTA GmbH, 96317 Kronach (DE)
(72) Erfinder: Schlee, Dieter, Dipl.-Ing. (FH), 96264 Altenkunstadt (DE)

(56) Entgegenhaltungen:
- EP-A- 0 483 463
- EP-A- 0 949 811
- DE-A1- 4 402 280
- DE-C1- 19 727 564
- GB-A- 2 256 549
- GIACHETTI J-L ET AL: "A COMMON CONDITIONAL ACCESS INTERFACE FOR DIGITAL VIDEO BROADCASTING DECODERS" IEEE TRANSACTIONS ON CONSUMER ELECTRONICS, IEEE INC. NEW YORK, US, Bd. 41, Nr. 3, August 1995 (1995-08), Seiten 836-841, XP000539543 ISSN: 0098-3063
- PATENT ABSTRACTS OF JAPAN Bd. 1997, Nr. 11, 28. November 1997 (1997-11-28) & JP 09 181667 A (NEC CORP), 11. Juli 1997 (1997-07-11)
- PATENT ABSTRACTS OF JAPAN Bd. 1997, Nr. 04, 30. April 1997 (1997-04-30) & JP 08 340524 A (SONY CORP), 24. Dezember 1996 (1996-12-24)

## Beschreibung

Die Erfindung betrifft ein Verfahren zum Belegen von Speicherplätzen mit Kanälen von empfangbaren, verschlüsselt übertragenen Diensten verschiedener Dienstanbieter in einer Tunereinrichtung in einem Empfangsgerät, bei dem manuell oder mittels automatischen Abstimmsystems eine Steuereinrichtung die Kanäle der empfangbaren Dienste absucht und der Reihe nach oder auf vorgegebene Speicherplätze speichert.

Digitale Rundfunksysteme ermöglichen es, dass Video- und Audiosignale bzw. digitale Fernsehsignale nach dem MPEG- Verfahren paketweise in bestimmten Datenformaten übertragen werden. Nach diesem Verfahren können Programmbeiträge bestimmter Programme zum Beispiel der ARD oder des ZDF übertragen werden. Es können aber auch diverse andere Dienste in gleicher Weise unverschlüsselt aber auch verschlüsselt übertragen werden, so dass nur Berechtigte mit ihrem digitalen Empfänger den jeweiligen Dienst nutzen können. Verschiedene Dienstanbieter verwenden eigene Verschlüsselungsnormen, sogenannte Conditional Access-Systeme, um ihr Video- und Audioangebot nur Nutzungsberechtigten zur Verfügung zu stellen. Innerhalb Europas verwenden die Dienstanbieter verschiedene CA-Systeme. Die bekanntesten sind unter den Namen lrDeto, BetaCrypt, SECA/Mediaguard, Viaccess, Nagra, Conax, Videoguard, Cryptoworks bekannt. Die Dienstanbieter weisen mindestens in einem der übersandten Blöcke durch einen sogenannten CA- System- ID (Conditional Access-Systems- Identifier) auf die gewählte Verschlüsselungsnorm hin. Dies geschieht durch Übertragung des CA- System- ldentifiers in einem Datenblock, der von einem Decoder mit Descrambler in dem Empfangsgerät auswertbar ist und zur Identifizierung und Entschlüsselung herangezogen wird. Der Decoder bzw. das Modul, das als Entschlüssler im Endgerät eingesetzt ist, enthält ebenfalls diesen Dienstanbieter spezifischen CA-System- Identifier, um eine Selektion der zugeordneten Datenpakete überhaupt vornehmen und um eine Entschlüsselung der verschlüsselten Daten über den Decoder bewerkstelligen zu können, damit die entschlüsselten Daten, z.B. Bild- und/oder Tondaten, weiterverarbeitet und wiedergegeben werden können. Jeder Dienstanbieter kann unter Verwendung des von ihm verwendeten Schlüssels eine Vielzahl von Diensten anbieten. Um das Empfangsgerät auf die einzelnen Dienste abstimmen zu können, wäre es praktisch notwendig, alle empfangbaren Dienste im Suchlauf zu ermitteln und abzulegen und diese gegebenenfalls auch im Bedarfsfall durch neue zu ergänzen. Dies würde einen außerordentlich hohen Speicherplatzbedarf und eine spezielle Speicherplatzverwaltung notwendig machen. Ferner ist eine listenmäßige umfangreiche Darstellung auf einem Bildschirm, also einem Anzeigegerät, zum Beispiel einem Fernsehgerät, notwendig, die unübersichtlich ist. Das Gerät selbst dekodiert den empfangenen Dienst oder zeigt an, dass der Dienst mit dem Gerät nicht entschlüsselt werden kann, da ein entsprechender Decoder nicht vorhanden ist.

Aus der DE 40 34 493 A1 ist eine Vorrichtung zur Senderprogrammierung eines Satellitenfernsehempfänger bekannt, die eine Bedieneinheit, einen Satellitentuner, eine Steuerschaltung und einen Satellitensenderspeicher aufweist. Zur Vereinfachung der Senderprogrammierung wird vorgeschlagen, den Satellitenempfänger zusätzlich mit einem Benutzerführungsinformationsspeicher und einem Satellitenparameterspeicher auszurüsten. Der Satellitenparameterspeicher wird bereits bei der Herstellung des Satellitenempfängers mit Satellitenparametern einer Vielzahl von Satelliten gefüllt. Bei der Senderprogrammierung werden die Parameter sämtlicher Programme eines gewünschten Satelliten auf einem Bildschirm dargestellt. In dieser Darstellung werden die Parameter eines gewünschten Programms mittels der Bedieneinrichtung angewählt und durch Betätigung einer Bestätigungstaste der Bedieneinrichtung in den Satellitensenderspeicher übernommen. Das Auswahlprogramm enthält dabei ebenfalls eine Aufforderung zur Eingabe, ob ein Descrambler angeschlossen oder nicht vorhanden ist. Der Benutzer muss dies jeweils durch eine Antwort "Ja" oder "Nein" bestätigen, so dass auch verschlüsselte Programme empfangen und dargeboten werden können. Dieses Programm gibt eine benutzerführungsunterstützte manuelle Auswahlmöglichkeit zwischen vorab gespeicherten Satellitenprogrammen an. Es ist weder ein automatischer Suchlauf noch eine automatischen Programmplatzzuordnung möglich.

Aus der DE 198 15 952 A1 ist ein Verfahren zur Belegung des Senderspeichers eines Rundfunkempfängers und/oder Datenempfängers bekannt, bei dem zunächst ein Sendersuchlauf durchgeführt wird, um eine Sendersuchlauftabelle zu generieren, in der Daten einer Vielzahl von einem oder mehreren ausgestrahlten Sender enthalten sind. Danach erfolgt ein Vergleich der Sendersuchlauftabelle mit einer im Rundfunkempfänger abgespeicherten benutzerspezifischen Sendertabelle zur Ermittlung von Sendern, die sowohl der Sendersuchlauftabelle als auch der benutzerspezifischen Sendertabelle angehören. Die Daten der bei diesem Vergleich ermittelten Sender werden im nichtflüchtigen Senderspeicher des Rundfunkempfängers abgelegt. Beim Suchlauf werden dabei auch Sender mit erfasst, die verschlüsselte Programme enthalten können, gleich ob nun diese Programme mit einem im Gerät vorhandenen Decoder oder Modul decodiert werden können oder nicht. Dies führt zu einer Programmauflistung, die nicht empfangbare Sender mit auflistet.

Aus der Fachzeitschrift RFE, Nr. 9/1998, Seiten 28 bis 31, ist die Architektur eines digitalen Satellitenreceivers bekannt, der eine Schnittstelle für Chipkarten aufweist, auf denen Entschlüsselungsalgorithmen enthalten sind, um empfangene Signale decodieren zu können. Die dabei zur Anwendung kommenden üblichen CA-Systeme sind die eingangs beschriebenen CA-Systeme verschiedener Dienstanbieter.

Aus der DE 19727564 C1 ist ein Verfahren zum Belegen von Programmplätzen mit Kanälen von empfangbaren Sendern in Tunereinrichtungen bekannt, bei dem manuell oder mittels eines automatischen Abstimmsystems, einer Speichereinrichtung und einer Steuereinrichtung die Kanäle der empfangbaren Sender abgesucht und der Reihe nach auf Programmplätzen gespeichert werden, bei dem die Zuordnung der Kanalnummern zu den Programmplätzen veränderbar ist. So ist es damit möglich, eine erste gespeicherte Kanalnummer auf einen eingestellten, mit einer zweiten Kanalnummer belegten Programmplatz zu wechseln, indem ein Austauschsignal erzeugt wird, durch das die Steuereinrichtung veranlasst wird, erste Kanalnummern durch zweite Kanalnummern bezüglich der belegten Programmplätze auszutauschen (Austauschmodus) und in der Speichereinrichtung einzuspeichern oder die Programmplatzbelegung und alle weiteren in Aufwärtsrichtung zu verschieben (Einfügemodus), wenn eine zweite Nummer in einen Programmplatz eingefügt wird, wobei die Programmplätze, die zugeordneten Kanalnummern und/oder die Bezeichnungen der Sendeanstalten auf einem Bildschirm listenmäßig dargestellt werden. Durch wahlfreie Markierung werden Programmplätze fortlaufend umsortiert oder zu Gruppen zusammengestellt und an ausgewählten Plätzen eingefügt oder Gruppen ausgetauscht. Um ein Programm anzuwählen, kann sodann aus der Tabelle mittels Cursor- Führung ein Programm ausgewählt werden. Auf dieses Programm wird sodann abgestimmt. Die entsprechenden Abstimmparameter sind in einem Speicher gespeichert. Die Liste kann durch einen elektronischen Suchlauf erstellt werden, eine bereits vorhandene Liste kann durch neu hinzugetretene Programme ergänzt werden, indem ein erneuter Suchlauf gestartet wird. Vor dem Start kann eingegeben werden, dass nur neue, noch nicht abgespeicherte Programme aufgenommen werden sollen.

Aus der DE 44 02 280 A1 ist ein automatisches Canal + Sendekanalspeichersystem bekannt, in welchem ein Mikrocomputer einen Canal + Dekoder steuert, der der Dekodierung eines verwürfelten Canal + Sendesignal mit automatischer Auswahl dient. Dabei wird ein vom Canal + Dekoder erhaltenes Canal + Erkennungssignal und ein aus einem Tunereingabe-Videosignal erkanntes Synchronisationserkennungssignal bei der Speicherung des verwürfelten Canal + Sendekanals im VCR verwendet, wodurch die separate Bestimmung von Speicherkanalpositionen für den Canal + Sendekanal nicht erforderlich ist.

Aus der GB 2 256 549 A ist ein einfaches Programmiersystem für Videokassettenrecorder bekannt, das den Empfang einer Vielzahl von Sendungen, einschließlich verschlüsselter, gestattet. Dieser VCR-Recorder kann in Verbindung mit einer Kabelbox betrieben werden, die verschlüsselte Signale, beispielsweise Canal +, zu entschlüsseln vermag. Die Signale können dann entschlüsselt aufgezeichnet werden. Es ist aber auch möglich, den VCR-Recorder direkt mit dem eingehenden Kabelanschluss zu verbinden und empfangene Programme, die verschlüsselt sind, verschlüsselt aufzuzeichnen und bei der Wiedergabe durch die Kabelbox für die Darstellung entschlüsseln zu lassen. Aus den auf dem Bildschirm aufgelisteten Programmen ist durch Cursorauswahl eine Programmierung möglich.

Aus der Fachzeitschrift "IEEE Transactions on Consumer Electronics 41 (1995) August, No. 3" ist ein Common Conditional Access Interface für digitale Videodecoder bekannt, um mittels verschiedener einsetzbarer Entschlüssler unterschiedliche verschlüsselte Programme decodieren zu können.

Des weiteren ist aus der EP 0 483 463 A2 ein Satellitenempfänger mit einer Bedieneinheit, einem Satellitentuner, einer Steuerschaltung und einem Satellitensenderspeicher bekannt. Zur Vereinfachung der Senderprogrammierung wird vorgeschlagen, den Satellitenempfänger zusätzlich mit einem Benutzerführungsinformationsspeicher und einem Satellitenparameterspeicher auszurüsten. Der Satellitenparameterspeicher wird bereits bei der Herstellung des Satellitenempfängers mit Satellitenparametern einer Vielzahl von Satelliten gefüllt. Bei der Senderprogrammierung werden die Parameter sämtlicher Programme eines gewünschten Satelliten auf einem Bildschirm dargestellt. In der Darstellung werden die Parameter eines gewünschten Programms mittels der Bedieneinheit angewählt und durch Betätigen einer Bestätigungstaste der Bedieneinheit in den Satellitensenderspeicher übernommen. Das Bedienprogramm ist dabei auch dafür ausgelegt, um den Benutzer im Dialog zu fragen, ob ein Descrambler angeschlossen ist. Der Benutzer ist aufgefordert, entweder "Ja" oder "Nein" einzugeben.

Der Erfindung liegt die Aufgabe zu Grunde, eine Selektion empfangbarer, verschlüsselter Dienste automatisch vorzunehmen und die Mittel dafür bereit zu stellen, um solche Dienste anzeigen zu können, und zwar ausschließlich nur solche, die auch tatsächlich dekodierbar sind. In weiterer Ausgestaltung der Erfindung sollen neben den Diensten, die verschlüsselt angeboten werden, auch unverschlüsselte Dienste mitverwaltet und zur Anzeige gebracht werden können.

Die Aufgabe löst die Erfindung durch Anwendung des im Anspruch 1 angegebenen Verfahrens in einer Tunereinrichtung in einem Empfangsgerät der gattungsgemäßen Art.

Grundsätzlich ist das Verfahren nicht auf digital übertragene Video- und Audiosignale beschränkt. Das Verfahren ist auch verwendbar für reine Datenübertragung wie Textübertragung, ferner auf analoge Übertragungsverfahren. Durch die Integration beispielsweise von CA- Modulen (Conditional Access Modulen) in einem DVB Empfangsteil ermöglicht die Erfindung die verschlüsselten Dienste für ein nachträglich gestecktes Cl-Modul (Common Interface Modul) zu suchen. Aus Platzgründen und unter Berücksichtigung von Kundenwünschen werden beispielsweise in einem digitalen Fernsehempfänger nicht alle DVB Dienste bzw. Programme, speziell die verschlüsselten, abgespeichert. Wird nun ein neues Cl- Modul gesteckt oder macht ein DVB Programmanbieter einen Update- Suchlauf für DVB Signale erforderlich, so wird dieses der Empfängerschaltung gemeldet. Der Fernsehempfänger oder auch der Benutzer entscheidet, wann dieser Suchlauf durchgeführt wird, wobei dies beispielsweise durch einen Menü gesteuerten Funktionsablauf sichergestellt sein kann. Im Falle der Auslegung eines automatischen Betriebes entscheidet das Empfangsgerät eigenständig, wann dieser Suchlauf mit den folgenden Menüs durchgeführt wird. Wird beispielsweise nachträglich in einen Schacht des Gerätes ein Modul zum Dekodieren von verschlüsselten Dienstbeiträgen eingeführt, so wird durch den damit hergestellten Kontakt automatisch die Steuereinrichtung veranlasst, auf das Modul zuzugreifen und aus dem dortigen Speicher das Datum auszulesen, das das Modul als Entschlüssler für bestimmte Dienste identifiziert. Diese Daten werden dann in einem Speicher, auf den die Steuereinrichtung unmittelbaren Zugriff hat, abgespeichert. Dies kann ein Zwischenspeicher sein, zum Beispiel ein flüchtiger RAM-Speicher oder aber auch ein nicht flüchtiger NVRAM-Speicher oder ein EEPROM. Auch ist es möglich zunächst die Daten in einem Zwischenspeicher abzulegen und erst dann, wenn der Suchlauf Sender festgestellt hat, die den Entschlüsselungscode benötigen, um die Dienste entschlüsseln zu können, in den nichtflüchtigen Speicher zu übernehmen..

Nach erfolgter Identifizierung kann dann unmittelbar ein Suchlauf erfolgen. Die Abprüfprozedur, ob es sich um ein neues Modul handelt, sollte im Hintergrund zu einer laufenden Sendung von der Steuereinrichtung vorgenommen werden. Wird festgestellt, dass das Modul neu ist und bisher noch nicht registriert wurde, so kann durch ein entsprechendes eingeschriebenes Programm eine Menüanzeige im laufenden Bild oder anstelle eines laufenden Bildes oder aber auch in einem Unterbild (PIP) erfolgen, das dem Benutzer Auswahlmöglichkeiten bietet, nämlich einen Suchlauf nach entsprechenden Sendern bzw. Programmen und Diensten sofort vorzunehmen oder dies zu einem späteren Zeitpunkt zu vollziehen. Das Gerät kann aber auch so programmiert sein, dass dann, wenn keine Auswahl erfolgt oder der Benutzer ein Suchlaufprogramm zum gegenwärtigen Zeitpunkt nicht wünscht, dies beim Abschalten des Gerätes durch einen Betriebsnachlauf des Gerätes bewerkstelligt wird oder beim Einschalten des Gerätes, bevor ein normaler Empfang oder eine normale Abstimmung möglich ist.

Wenn das Empfangsgerät beispielsweise Bestandteil eines Aufzeichnungsgerätes ist, zum Beispiel eines Videorekorders oder eines Harddiskrekorders (HDR), und das Gerät sich bereits im Modus Aufzeichnung befindet oder der Aufzeichnungsbetrieb in einem Zeitabschnitt nach dem Einführen eines Entschlüsselungsmoduls ausgeführt wird, der kürzer ist als die Suchlaufprozedur, so kann vorgesehen sein, dass die Steuereinrichtung keinen automatischen Suchlauf auslöst, um den laufenden Aufzeichnungsbetrieb nicht zu unterbrechen.

Bei Geräten mit mehreren Tunereinrichtungen können selbstverständlich solche Prozesse parallel laufen und die Steuereinrichtung so programmiert sein, dass der Suchlauf mit der einen Tunereinrichtung durchgeführt wird, während die andere Tunereinrichtung autark unter Zuhilfenahme des Entschlüsslers die Aufzeichnung fortsetzt oder aber auch die Darstellung, wenn es sich um Bilddarstellung auf dem Bildschirm handelt.

Selbstverständlich ist es auch möglich, erklärende Texte in einem Benutzermenü einzufügen, wenn infolge des Einsetzens eines neuen Entschlüsselungsmoduls dem Benutzer signalisiert wird, dass hier nach neuen Diensten gesucht werden kann. Wird eine Suchlaufanfrage durch Eingabe eines entsprechenden Steuerbefehls, zum Beispiel "Ende", beendet, so kann vorgesehen sein, dass im Falle, dass das Gerät in den Standby- Betrieb umgeschaltet wird, der Suchlauf dann beginnt bzw. dann wenn aus dem Standby- Betrieb in den Normalbetrieb wieder geschaltet wird. Auch diese Steuerungen sind möglich. In jedem Fall wird das zum Entschlüsselungsmodul (Cl- Modul = Common- Interface Modul) gehörende Programm bzw. Dienstleistung gefunden, sofern solche übertragen werden, wodurch der Suchmerker zurückgesetzt und der Suchlauf beendet wird. Die Programmumschaltung bzw. die Abstimmung des Gerätes auf Kanäle verschiedenster Dienste kann in bekannter Weise über die Tastatur, eine Fernbedienung oder durch Cursor- Führung unter Aufruf aller abgespeicherten Dienste und Auswahl derselben erfolgen.

Beim Abstimmen auf einen Kanal eines verschlüsselten Dienstes überprüft die Steuereinrichtung, ob der verschlüsselte Dienstbeitrag mit dem vorhandenen Decoder oder Modul entschlüsselbar ist. Sodann erfolgen die Entwürfelung des verschlüsselten Dienstes und die bildliche bzw. akustische Wiedergabe durch die mit dem Empfangsgerät gekoppelten Anzeige- und Lautsprecheranordnungen sowie die dazugehörenden vorgeschalteten Signalverarbeitungsschaltungen, wie sie beispielsweise in Femsehempfangsgeräten, in Multimediageräten oder auch in Audiogeräten wiederzufinden sind. Das erfindungsgemäße Verfahren ist also nicht nur auf Fernsehsignale in analoger oder digitaler Form beschränkt, sondern kann auch für Audiosignale, zum Beispiel DAB- Signale, verwendet werden, die neben den Audiosignalen auch Datensignalübertragungen ermöglichen, die selbstverständlich auch verschlüsselt seien können.

Um nun aus einer Übersichtstabelle die entsprechende Auswahl der Dienste dem Benutzer zu ermöglichen, werden den Speicherplätzen nicht nur die Daten zugeordnet, die das Entschlüsselungsverfahren repräsentieren, zum Beispiel der CA- System- ID (Conditional Access Identifier), sondern es werden den Speicherplätzen auch die Dienstbezeichnungen oder Kurznamen der Dienstanbieter mit auf dem Bildschirm dargestellt, wie dies aus der eingangsgenannten Druckschrift vorbekannt ist, um eine Auswahlanzeige zu bieten. Der eigentliche Descramblerschlüssel wird gesondert selektiert. Der CA-System-ID dient nur zur Kennzeichnung des Verfahrens.

Die Dienstleistungen können alphabetisch listenmäßig dargestellt oder nach bestimmten Bewertungs- und Auswahlkriterien und Kategorien zusammengestellt werden, beispielsweise können auf diese Art und Weise alle Dienste, die Sport- Informationen betreffen, zusammengefasst werden oder auch alle Dienste, die Banken und Börseninformation beinhalten oder andere Sachthemen. Auch kann zwischen verschiedensprachigen Programmen unterschieden werden.

Ist nun einmal die Übersichtsseite wunschgemäß zusammengestellt, so kann durch eine Menüsteuerung mit der durch Cursor- Führung oder durch Anwahl eines bestimmten Anzeigeplatzes mittels Zehnertastatur oder durch Auswahl einer Rangordnungszahl, die in den Informationen in der Darstellung vorangestellt ist, mittels Fernbedienung oder auch einer Ortsbedienung am Gerät die Tunereinrichtung veranlasst werden auf den entsprechenden Kanal abzustimmen, um die gewünschte Dienstleistung empfangen zu können. Es ist darüber hinaus aber auch möglich, innerhalb der Darstellung Verschiebungen wahlweise vorzunehmen, indem einzelne Anzeigeplätze verschoben werden oder aber auch Gruppen von mehreren Anzeigeplätzen. Hierfür sind Austausch-, Einfüge-, und Verschiebemodi aus der eingangs genannten Patentschrift bekannt.

Bedingt durch die hohe Anzahl an Dienstanbietern, die verschlüsselte Programme und Dienstleistungen anzubieten beabsichtigen bzw. bereits anbieten, ist es bekannt, eine vereinheitlichte Schnittstelle für unterschiedliche Entschlüsselungsmodule zu verwenden, ein sogenanntes Common Interface. Die Module selbst sind in der Regel hardwaremäßig ausgeführt und/oder aber weisen sie einen Chipkartenleser auf, in dem von verschiedenen Dienstanbietern Chipkarten eingesetzt werden können. Die Leseeinrichtung selbst, die sich in dem Conditional Access Modul befindet, weist einen Speicher auf, in dem der CA- System- Identifier zur Identifizierung des Moduls für den oder die Dienstanbieter, die sich auf einen bestimmten CA-System- ID Code festgelegt haben, abgespeichert ist. Dieser wird von dem Gerät nach dem angegebenen Verfahren abgespeichert und für die Identifizierung der späteren Entschlüsselung empfangbarer Dienstbeiträge herangezogen. Die Prozedur des CA- System- ldentifiers erfolgt dabei in der vorher beschriebenen Art und Weise.

Beim Einführen eines neuen Common Interface Moduls in die Aufnahmeeinrichtung des Gerätes kann beim Überprüfen, ob der entsprechende CA-System- Identifier bereits abgespeichert ist, und beim Feststellen, dass dies der Fall ist, das Steuerprogramm einen Suchlauf von vorn herein ausschalten, da dieser ja bereits vorgenommen worden ist. Diese Prozedur kann, wie vorher schon angegeben, im Hintergrund, während des Betrachtens eines anderen Sendebeitrags erfolgen. Es ist darüber hinaus bekannt, dass einzelne Module verschiedene CA- System- Identifier gespeichert aufweisen, also für verschiedene Entschlüsselungssysteme geeignet sind. Auch dieses kann von dem System selbstverständlich erfasst werden.

Die einzelnen Verfahrensschritte sind in den Unteransprüchen zum Anspruch 1 im einzelnen angegeben.

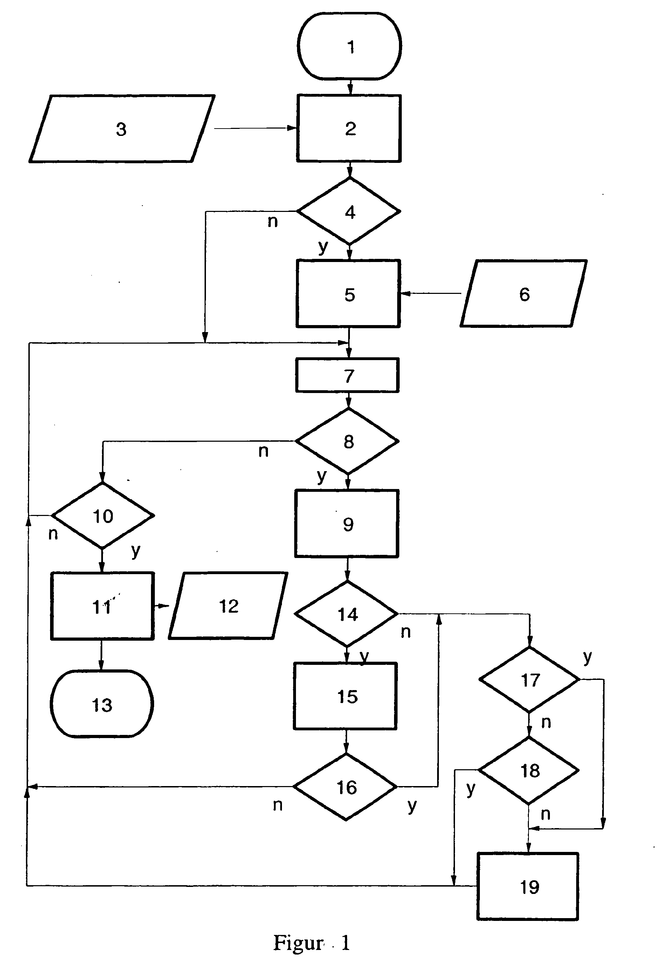

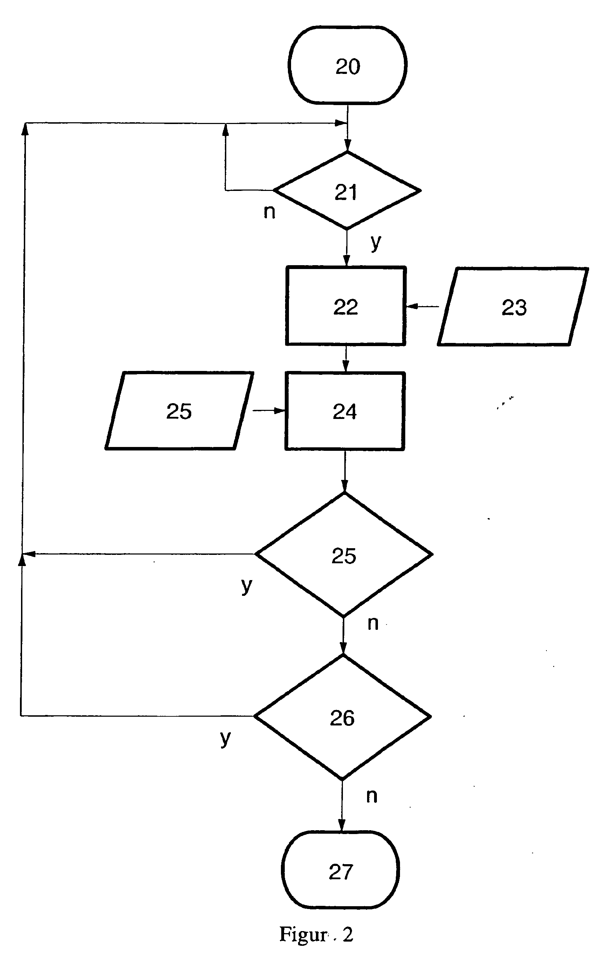

Die Erfindung wird nachfolgend anhand der in den Figuren 1 und 2 dargestellten Flussdiagramme bezogen auf zwei Ausführungsbeispiele ergänzend erläutert.

Figur 1 gibt ein Flussdiagramm für das automatische Suchen von Programmen bzw. Diensten an. Dies erfolgt beispielsweise bei einem Fernsehgerät nach dem Aufstellen des Fernsehgerätes im ersten Durchlauf, kann aber wahlfrei jederzeit wiederholt werden.

Im Schritt 1 wird durch Computereingabe eines Startbefehls zum Beispiel über einen Fernbedienungsgeber das Programm "Automatisch Suchen" aktiviert. Im Schritt 2 werden die Suchlaufparameter eingelesen, die durch Benutzereingabe oder Vorbelegung definiert sind. Zum Beispiel: Auswahl Satellit, Kabel, oder terrestrischer Empfang; Umfang: alle Programme, was erforderlich ist, wenn das Gerät noch nicht programmiert ist und neu aufgestellt wird oder "nur neue Programme" und/oder ab welchem Programmspeicherplatz bzw. Dienstspeicherplatz, die neu hinzugetretenen Programme oder die Dienste, die im gesamten Suchlauf aufgefunden und abgespeichert werden sollen. Diese Benutzereingabe oder Vorbelegung erfolgt im Schritt 3 zum Beispiel durch Menüsteuerung, wenn nach Schritt 2 die Suchlaufparameter eingelesen werden sollen.

Im Schritt 4 fragt das System nun nach, ob ein CICAM, ein Common Interface/ Conditional Access Modul gesteckt ist oder nicht. Anstelle eines CICAM kann auch ein an sich bekannter Decoder für Entschlüsselungen von verschlüsselten Daten im Gerät präsent sein. Wird in der Abfrage festgestellt ja (y), so wird in einem 5. Schritt durch die Steuereinrichtung veranlasst, dass der CA- System- ID bzw. mehrere CA- System- lDs auf einem CICAM ausgelesen und in einen Speicher, der ein Zwischenspeicher sein kann, eingelesen werden und eine Liste erstellt. Die Entnahme erfolgt gemäß dem angedeuteten Schritt 6 aus dem CICAM Speicher.

Wird hingegen festgestellt, dass kein CICAM gesteckt ist, so wird der Schritt 5 übersprungen und, wie aus dem links stehenden Pfeil ersichtlich, im Fall nein (n) sofort auf Schritt 7 übergegangen, nämlich den Schritt "Programm suchen". Im Falle, dass CA- System- Identifiers festgestellt werden, wird nach der Registrierung der CA- System- Identifiers ebenfalls auf Schritt 7 übergegangen und das Programm bzw. die Dienste werden gesucht. Wird nun während eines Suchlaufes ein Programm oder Dienst gefunden (Schritt 8), so werden die Programmparameter aus dem Datenstring bei digital übertragenen Programmen und Diensten herausgelesen, beispielsweise die Frequenz, Name, PIDs, CA- System- Identifiers usw. und zwischengespeichert oder auch fest abgespeichert, was der Schritt 9 verdeutlicht. Nach dem Schritt 9 wird im Schritt 14 nun festgestellt, ob es sich um ein verschlüsseltes Programm handelt oder um ein nicht verschlüsseltes. Im Falle, dass es sich um ein verschlüsseltes Programm handelt (y), wird nachgesucht, ob der im Schritt 5 ermittelte CA- System- Identifier abgespeichert ist, der mit dem System- Identifier des Programms übereinstimmt. Hierzu wird auf die Liste zugegriffen, in der die CA- System- Identifier festgehalten sind. Wird im Schritt 16 bestätigt, dass ein CA- System- Identifier in der Liste gefunden wurde (y), so veranlasst die Steuereinrichtung, dass das verschlüsselte Programm wie auch alle unverschlüsselten gemäß Schritt 17 entweder alle gespeichert werden, oder falls das Auswahlprogramm festlegt, dass nur neue aufgefundene Programme gespeichert werden sollen, gemäß Schritt 18 nur die neu aufgefundenen abgespeichert werden. Sollen alle Programme gemäß Schritt 17 gespeichert werden, so werden diese direkt in den Speicher gemäß Schritt 19 übernommen und hieraus wahlweise aufgerufen, um sie auf einem Display listenmäßig darstellen zu können. Wird beim Schritt 18 festgestellt, dass ein Programm bereits gespeichert ist, wird der Suchlauf über die Schleife fortgesetzt.

Wird im Schritt 8 festgestellt, dass kein Programm auffindbar ist (n), so wird im Schritt 10 festgestellt, ob das Bereichsende des Suchbereiches bereits erreicht ist. Ist dies nicht der Fall so wird der Suchlauf gemäß der eingezeichneten Schleife weiter durchgeführt. Wird in dem Schritt 10 hingegen festgestellt, dass das Bereichsende erreicht ist, so wird die zwischengespeicherte Liste der CA- System- ldentifiers in einen nicht löschbaren Speicher, einen NVRAM oder EEPROM übernommen bzw. dort bereits gespeicherte CA- System- Identifiers durch die neu hinzugekommenen ergänzt. Dies erfolgt durch Schritt 11 und die Abspeicherung im Schritt 12. Das System veranlasst dann im Schritt 13, dass der Suchlauf beendet ist, was auf dem Display angezeigt werden kann. Nach Ablauf dieses Programms sind alle abstimmbaren Dienste in dem Speicher gemäß Schritt 19 gespeichert und können wahlweise aufgerufen werden.

Figur 2 gibt in Form eines Flußdiagramms die Schritte an, die erforderlich sind, um beim Einführen eines neuen Entschlüsselungsmoduls einen Suchlauf anfordern zu können.

Im Schritt 20 wird die Prozedur beispielsweise beim Einschalten des Gerätes oder durch Einstecken eines neuen CICAM-Moduls ausgelöst. Im Schritt 21 wird festgestellt, ob das eingesteckte Modul ein neues Modul ist. In Abhängigkeit von dieser Feststellung geht im Falle "nein" das Computerprogramm in den dargestellten Überwachungszyklus über. Im Falle, dass festgestellt wird, dass es sich um ein neues Modul handelt (y) wird gemäß Schritt 22 durch die Steuereinrichtung veranlasst, dass die im neuen CICAM-Modul gespeicherten CA- System- Identifiers aus diesem in Schritt 23 ausgelesen und in einem Speicher listenmäßig abgespeichert werden. Im Schritt 24 wird aus dem nicht flüchtigen Speicher die bereits bestehende Liste der CA- System- ldentifiers ausgelesen und mit der ersten Liste im Schritt 25 verglichen. Wird festgestellt, dass die neu ermittelten CA- Systemldentifiers komplett in Liste 2 enthalten sind, so wird der Suchlauf ebenfalls abgebrochen. Wird hingegen festgestellt, dass die Liste nicht vollständig enthalten ist, so wird im Schritt 26 überprüft, ob eine Timerprogrammierung aktiviert ist, das heißt eine laufende Aufzeichnung eines eingestellten Programms oder Dienstes bereits erfolgt ist. Ist dieses der Fall, so wird kein Suchlauf angefordert. Ist eine Timerprogrammierung hingegen nicht aktiviert (n), so erfolgt eine Suchlaufanforderung zum Beispiel durch Darstellung eines Menüs auf dem Display oder, wenn entsprechend das Programm dieses vorsieht, zu einem späteren Zeitpunkt.

## Patentansprüche

1. Verfahren zum Belegen von Speicherplätzen mit Kanälen von empfangbaren, verschlüsselt übertragenen Diensten verschiedener Dienstanbieter in einer Tunereinrichtung in einem Empfangsgerät, bei dem manuell oder mittels automatischen Abstimmsystems eine Steuereinrichtung die Kanäle auf empfangbare Dienste absucht und der Reihe nach oder auf vorgegebenen Speicherplätzen speichert, **dadurch gekennzeichnet,**
**dass** die Steuereinrichtung automatisch erfasst, ob ein Decoder oder Modul zum Dekodieren von verschlüsselten Dienstbeiträgen eines Dienstes im Empfangsgerät vorhanden ist, zu welchem Zweck ein vom Decoder oder Modul abgegebenes oder auslesbares Datum oder ein anderes abgegebenes Signal ausgewertet wird, das den Decoder oder das Modul als Entschlüssler für bestimmte Dienste identifiziert,
**dass** beim Abstimmen auf einen Kanal eines verschlüsselten Dienstes die Steuereinrichtung überprüft, ob der vom Dienst gesendete verschlüsselte Dienstbeitrag mit dem vorhandenen Decoder oder Modul entschlüsselbar ist,
und **dass** die Steuereinrichtung die Abstimmdaten des bestimmten Dienstes im Speicher nur dann abspeichert, wenn die Identifizierung des Dienstes erfolgt ist.

2. Verfahren nach Anspruch 1, **dadurch gekennzeichnet, dass** die den Diensten zugeordneten Speicherplätze und/oder die Dienstbezeichnungen oder Kurznamen der Dienstanbieter auf einem Bildschirm des Empfangsgerätes oder eines angeschlossenen Anzeigegerätes listenmäßig oder nach bestimmten Bewertungs- und Auswahlkriterien oder Kategorien zusammengestellt dargestellt werden.

3. Verfahren nach Anspruch 2, **dadurch gekennzeichnet, dass** durch eine Menü-Steuerung mit der durch Cursor- Führung oder durch Anwahl eines bestimmten Anzeigeplatzes oder durch Auswahl einer Rangordnungszahl des ausgewählten bestimmten Anzeigeplatzes mittels einer Fernbedienung oder durch Betätigen eines Einstellelementes einer Ortsbedienung am Empfangsgerät ein Steuersignal in der Steuereinrichtung generiert wird, das eine Anzeigesteuerung veranlasst, den ausgewählten Anzeigeplatz zu markieren und eine Umschaltung auf einen der vorgebbaren Modi (Austauschmodus, Einfügemodus, Verschiebemodus) zu bewirken.

4. Verfahren nach Anspruch 3, **dadurch gekennzeichnet, dass** mehrere hintereinander liegende Anzeigeplätze markiert und gemeinsam verschoben werden.

5. Verfahren nach einem der Ansprüche 1 bis 4, **dadurch gekennzeichnet, dass** die Steuereinrichtung im Suchlauf die Tunereinrichtung auf Kanäle mit verschlüsselten Diensten und unverschlüsselten Diensten und Programmen abstimmt, und dass sowohl unverschlüsselte Programme und Dienste als auch die der verschlüsselten, dekodierbaren Dienste im Speicher abgespeichert werden.

6. Verfahren nach Anspruch 5, **dadurch gekennzeichnet, dass** bei Feststellung eines bereits gespeicherten Kanals eines verschlüsselten Dienstes während eines Suchlaufs nur dann ein weiterer Speicherplatz belegt wird, wenn die Steuereinrichtung feststellt, dass der verschlüsselt empfangene Dienstbeitrag von einem verschlüsselten Dienst empfangen wird, der vom gespeicherten abweicht und vom Decoder oder Modul entschlüsselbar ist, und das Gerät über einen entsprechend identifizierten Decoder verfügt.

7. Verfahren nach einem der vorhergehenden Ansprüche, **dadurch gekennzeichnet, dass** das Gerät eine Common- Interface- Schnittstelle für den Einsatz mindestens eines Entschlüsselungsmoduls mit oder ohne Chipkarte enthält.

8. Verfahren nach Anspruch 7, **dadurch gekennzeichnet, dass** das Common-Interface- Modul eine Aufnahme für mindestens eine Chipkarte aufweist und in dem Modul mindestens ein CA- System (Conditional Access) -ID (Identifier) abgespeichert ist, den die Steuereinrichtung über einen Bus der Schnittstelle abfragt.

9. Verfahren nach Anspruch 8, **dadurch gekennzeichnet, dass** die abgefragten CA- System - ID in einem Speicher gesammelt werden, dass aber nur die CA- System- ID aus dem Speicher aufrufbar sind, deren zugeordnete Module tatsächlich im Gerät zur Zeit verfügbar sind.

10. Verfahren nach Anspruch 7, 8 oder 9, **dadurch gekennzeichnet, dass** das Common Interface ein oder mehrere Leseeinrichtungen für Conditional Access Module aufweist, und dass die Steuereinrichtung alle Module identifiziert und die CA-System- ID der einzelnen zur Anwendung kommenden Module in einem Speicher abspeichert.

11. Verfahren nach einem der vorhergehenden Ansprüche, **dadurch gekennzeichnet, dass** die Steuereinrichtung beim Einführen eines Common Interface Moduls nur dann den augenblicklichen Betrieb des Empfangsgerätes unterbricht und einen Suchlauf auslöst, wenn der Benutzer dies ausdrücklich wünscht und einen Steuerbefehl, vorzugsweise mittels Fernbedienung, eingibt oder eine Steuerfunktion aus einem dargestellten Menü auswählt, anderenfalls wird der Suchlauf zu einem späteren Zeitpunkt oder wenn das Gerät abgeschaltet (Standby), eingeschaltet und/oder auf einen anderen Betriebszustand umgeschaltet wird, durchgeführt.

12. Verfahren nach Anspruch 11, **dadurch gekennzeichnet, dass** mit dem Einführen des Moduls im Hintergrund eine Überprüfung erfolgt, ob der CA-System- Identifier bereits im Speicher registriert ist oder nicht.

13. Verfahren nach Anspruch 10, 11 oder 12, **dadurch gekennzeichnet, dass** die Auswertung mehrerer auf einem Modul vorhandener CA- System- Identifier erfolgt.

14. Verfahren nach einem der Ansprüche 10 bis 13, **dadurch gekennzeichnet, dass** mit dem Einführen des Moduls ein Steuermenü aktiviert wird, wenn die Überprüfung ergeben hat, dass der oder die CA-System-ldentifier noch nicht abgespeichert ist oder sind, wobei das Steuermenü den Benutzer auffordert einen automatischen Suchlauf zu generieren, um alle Dienste abspeichern zu können, die unter den jeweiligen CA- System- ID empfangbar sind, oder aber diese Prozedur auf einen späteren Zeitpunkt verschiebt.

15. Verfahren nach einem der vorhergehenden Ansprüche, **dadurch gekennzeichnet, dass** im Falle einer Timerfunktion im Gerät bei eingeschaltetem Timer mindestens der Suchlauf bei Feststellung neuer CA System ID verhindert und erst beim erneuten Einschalten oder Ausschalten des Gerätes automatisch oder menügesteuert vorgenommen wird.

16. Verfahren nach Anspruch 2 oder 9, **dadurch gekennzeichnet, dass** nur die verschlüsselten Dienste alleine oder zusammen mit den unverschlüsselten Programmen und/oder Diensten aufgezeigt werden, die tatsächlich über im Gerät vorhandene Entschlüsselungsmodule oder Decoder entschlüsselt werden können.

17. Empfangsgerät mit einer Tunereinrichtung, einem Abstimmsystem und einer nach den Verfahren von Anspruch 1 und/oder nach einem oder mehreren der vorhergehenden Ansprüche arbeitenden Steuereinrichtung.

## Claims

1. Method of occupying memory locations with channels of receivable services, which are transmitted in coded form, of different service providers in a tuner device in a receiver, in which a control device seeks the channels, manually or by means of an automatic tuning system, for receivable services and stores them in order or at predetermined memory locations, **characterised in that** the control device automatically detects whether a decoder or module for decoding coded service contributions of a service is present in the receiver, for which purpose a data item, which is supplied or readable by the decoder or module, or another supplied signal which identifies the decoder or the module as decoding means for specific services is evaluated, that on tuning to a channel of a coded service the control device checks whether the coded service contribution transmitted by the service can be decoded by the decoder or module which is present and that the control device stores the tuning data of the specific service in the memory only when the identification of the service has taken place.

2. Method according to claim 1, **characterised in that** the memory locations associated with the services and/or the service designations or the abbreviations of the service providers are represented as a list on a display screen of the receiver or a connected display apparatus or are represented in collated form in accordance with specific evaluation and selection criteria or categories.

3. Method according to claim 2, **characterised in that** a control signal is generated in the control device by a menu control by cursor guidance or by selection of a specific display location or by selection of a priority number of the selected specific display location by means of a remote control or by actuation of a setting element of a local control at the receiver, which control signal causes a display control means to mark the selected display location and to effect switching-over to one of the predeterminable modes (exchange mode, insertion mode, displacement mode).

4. Method according to claim 3, **characterised in that** several display locations disposed in succession are marked and are displaced in common.

5. Method according to one of claims 1 to 4, **characterised in that** the control device in the search run tunes the tuner device to channels with coded services and uncoded services and programs and that not only uncoded programs and services, but also the coded, decodable services are stored in the memory.

6. Method according to claim 5, **characterised in that** on detecting an already stored channel of a coded service during a search run a further memory location is occupied only if the control device establishes that the coded, received service contribution is received by a coded service which differs from the stored one and is decodable by the decoder or module and the apparatus has a correspondingly identified decoder.

7. Method according to one of the preceding claims, **characterised in that** the apparatus comprises a common interface for use of at least one decoding module with or without a chipcard.

8. Method according to claim 7, **characterised in that** the common interface module has a receptacle for at least one chipcard and at least one CA (Conditional Access) system ID (identifier), which interrogates the control device by way of a bus of the interface, is stored in the module.

9. Method according to claim 8, **characterised in that** the interrogated CA system IDs are collected in a memory, but only the CA system ID of which the associated module is actually currently available in the apparatus can be called up from the memory.

10. Method according to claim 7, 8 or 9, **characterised in that** the common interface has one or more reading devices for conditional access modules and that the control device identifies all modules and the CA system ID stores the individual modules, which come into use, in a memory.

11. Method according to one of the preceding claims, **characterised in that** the control device on introduction of a common interface module interrupts the current operation of the receiver and triggers a search run only if the user expressly desires this and inputs a control command, preferably by means of remote control, or selects a control function from an illustrated menu, but otherwise the search run is carried out at a later point in time or when the apparatus is switched off (standby), switched on and/or switched over to another operating state.

12. Method according to claim 11, **characterised in that** with the introduction of the module a check is carried out in the background as to whether or not the CA system identifier is already registered in the memory.

13. Method according to claim 10, 11 or 12, **characterised in that** the evaluation of several CA system identifiers, which are present on a module, takes place.

14. Method according to one of claims 10 to 13, **characterised in that** with the introduction of the module a control menu is activated when the check has shown that the CA system identifier or identifiers is or are not yet stored, wherein the control menu requires the user to generate an automatic search run in order to be able to store all services which are receivable under the respective CA system ID or, however, to shift this procedure to a later point in time.

15. Method according to one of the preceding claims, **characterised in that** in the case of a timer function in the apparatus at least the search run on detection of a new CA system ID is prevented when the timer is switched on and is undertaken, automatically or under menu control, only when the apparatus is switched on or off again.

16. Method according to claim 2 or 9, **characterised in that** only the coded services alone or together with the uncoded programs and/or services, which can actually be decoded by way of decoding modules or decoders present in the apparatus, are recorded.

17. Receiver with a tuner device, a tuning system and a control device which operates according to the method of claim 1 and/or according to one or more of the preceding claims.

## Revendications

1. Procédé pour occuper des emplacements de mémoire avec des canaux de services chiffrés pouvant être reçus de différents fournisseurs de services dans un dispositif de syntonisation dans un appareil de réception, dans le cadre duquel un dispositif de commande recherche manuellement ou par le biais d'un système d'accord automatique les canaux sur les services pouvant être reçus et mémorise l'ordre selon ou sur des emplacements de mémoire prédéfinis, **caractérisé en ce que**
le dispositif de commande détecte automatiquement s'il existe un dispositif de déchiffrement ou un module de déchiffrement des contributions chiffrées d'un service dans l'appareil de réception, pour l'utilisation duquel une donnée lisible ou fournie par un dispositif de déchiffrement ou un module ou un autre signal fourni est analysé, lequel identifie le dispositif de déchiffrement ou le module comme déchiffrement pour les services donnés,
**en ce que**, lors de l'accord sur un canal d'un service chiffré, le dispositif de commande vérifie si la contribution au service chiffrée envoyée par le service peut être déchiffrée par le décodeur ou le module existant,
et **en ce que** le dispositif de commande n'enregistre les données d'accord du service déterminé dans la mémoire que lorsque l'identification du service a réussi.

2. Procédé selon la revendication 1, **caractérisé en ce que** les emplacements de mémoire affectés aux services et/ou les désignations de service ou désignations synthétiques des fournisseurs de services sont représentés de façon regroupée, sur l'écran de l'appareil de réception ou d'un appareil d'affichage connecté, sous forme de liste ou selon des critères d'analyse et de sélection donnés ou des catégories.

3. Procédé selon la revendication 2, **caractérisé en ce qu'**un signal de commande est généré dans le dispositif de commande par une commande par menu avec commande par un curseur ou par la sélection d'un point d'affichage donné ou par la sélection d'un classement par rang du point d'affichage donné choisi au moyen d'une télécommande ou en actionnant un élément de réglage d'une commande sur site au niveau de l'appareil de réception, lequel signal incite une commande d'affichage à marquer le point d'affichage sélectionné et à entraîner une commutation sur un des modes prédéfinis (mode d'échange, mode d'insertion, mode de déplacement).

4. Procédé selon la revendication 3, **caractérisé en ce que** plusieurs points d'affichage se trouvant les uns derrière les autres sont marqués et déplacés ensemble.

5. Procédé selon l'une quelconque des revendications 1 à 4, **caractérisé en ce que** le dispositif de commande accorde, lors d'une recherche, le dispositif de syntonisation sur des canaux avec des services chiffrés et des services et des programmes non chiffrés, et **en ce que** les programmes et les services non chiffrés ainsi que les services décodables chiffrés sont enregistrés dans la mémoire.

6. Procédé selon la revendication 5, **caractérisé en ce que**, lors de la détermination d'un canal déjà mémorisé d'un service chiffré, pendant une recherche, seul un autre emplacement de mémoire est occupé lorsque le dispositif de commande détermine que la contribution au service chiffrée reçue est reçue par un service chiffré, lequel diffère de celui mémorisé et peut être déchiffré par un dispositif ou un module décodeur, et **en ce que** l'appareil dispose d'un dispositif décodeur identifié en conséquence.

7. Procédé selon l'une quelconque des revendications précédentes, **caractérisé en ce que** l'appareil contient une interface « Common Interface » permettant l'utilisation d'au moins un module de déchiffrement avec ou sans carte à puce.

8. Procédé selon la revendication 7, **caractérisé en ce que** le module « Common Interface » comporte un logement pour au moins une carte à puce et qu'au moins un ID (identifiant) de système d'accès conditionnel (CA) est mémorisé dans le module, lequel interroge le dispositif de commande via un bus de l'interface.

9. Procédé selon la revendication 8, **caractérisé en ce que** les ID de système CA demandés sont regroupés dans une mémoire et **en ce que** seuls les ID de système CA peuvent être appelés à partir d'une mémoire, dont les modules affectés à ce moment là sont réellement disponibles dans l'appareil.

10. Procédé selon les revendications 7, 8 ou 9, **caractérisé en ce que** l'interface « Common Interface » comporte un ou plusieurs dispositifs de lecture pour les modules d'accès conditionnel, et **en ce que** le dispositif de commande identifie tous les modules et enregistre les ID système CA des modules individuels appliqués dans une mémoire.

11. Procédé selon l'une quelconque des revendications précédentes, **caractérisé en ce que** le dispositif de commande n'interrompt que le fonctionnement actuel de l'appareil de réception lors de l'insertion d'un module Common Interface et déclenche une recherche lorsque l'utilisateur le souhaite expressément et donne une instruction de contrôle, de préférence au moyen d'une télécommande, ou choisit une fonction de commande dans le menu représenté, sinon, la recherche est exécutée plus tard ou lorsque l'appareil est déconnecté (veille), connecté et/ou commuté dans un autre mode de fonctionnement.

12. Procédé selon la revendication 11, **caractérisé en ce qu'**il est vérifié en arrière-plan, avec l'insertion du module, si l'identifiant système CA est déjà enregistré ou non dans la mémoire.

13. Procédé selon les revendications 10, 11 ou 12, **caractérisé en ce qu'**une analyse de plusieurs identifiants système CA existants sur le module est exécutée.

14. Procédé selon l'une quelconque des revendications 10 à 13, **caractérisé en ce qu'**un menu de commande est activé avec l'insertion du module, lorsque la vérification a révélé que le ou les identifiants système CA n'a/n'ont pas encore été enregistrés, le menu de commande demandant à l'utilisateur de générer une recherche automatique afin de pouvoir enregistrer tous les services qui peuvent être reçus sous l'ID système CA correspondant, ou cette procédure est remise à plus tard.

15. Procédé selon l'une quelconque des revendications précédentes, **caractérisé en ce que**, dans le cas d'une fonction de temporisation dans l'appareil, lorsque la temporisation est déclenchée, la recherche au moins est empêchée lors de la détermination de nouveaux ID système CA et est effectuée, d'abord, automatiquement ou par le biais du menu lors d'une nouvelle connexion ou déconnexion de l'appareil.

16. Procédé selon les revendications 2 ou 9, **caractérisé en ce que** seuls les services codés sont affichés individuellement ou collectivement avec les programmes et/ou services non codés, lesquels peuvent être réellement déchiffrés via les dispositifs décodeur ou les modules de déchiffrement existants dans l'appareil.

17. Appareil de réception avec un dispositif de syntonisation, un système d'accord et un dispositif de commande fonctionnant selon le procédé de la revendication 1 et/ou selon une ou plusieurs des revendications précédentes.
